(19) Europäisches Patentamt / European Patent Office / Office européen des brevets

(11) **EP 4 245 520 A1**

(12) **EUROPEAN PATENT APPLICATION**
published in accordance with Art. 153(4) EPC

(43) Date of publication:
20.09.2023  Bulletin 2023/38

(21) Application number: 21891555.1

(22) Date of filing: 08.10.2021

(51) International Patent Classification (IPC):
*B32B 9/00* (2006.01)     *B32B 9/04* (2006.01)
*B32B 27/26* (2006.01)     *B32B 27/40* (2006.01)
*B65D 65/40* (2006.01)     *C08K 5/54* (2006.01)
*C08K 7/00* (2006.01)     *C08L 29/04* (2006.01)
*C08L 75/04* (2006.01)     *C08L 101/14* (2006.01)
*C09D 129/02* (2006.01)     *C09D 129/04* (2006.01)
*C09D 175/04* (2006.01)

(52) Cooperative Patent Classification (CPC):
B32B 9/00; B32B 9/04; B32B 27/26; B32B 27/40;
B65D 65/40; C08K 5/54; C08K 7/00; C08L 29/04;
C08L 75/04; C08L 101/14; C09D 7/63; C09D 7/65;
C09D 129/02; C09D 129/04; C09D 175/04

(86) International application number:
PCT/JP2021/037398

(87) International publication number:
WO 2022/102308 (19.05.2022 Gazette 2022/20)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 12.11.2020  JP 2020188672

(71) Applicant: TOPPAN INC.
Tokyo 110-0016 (JP)

(72) Inventors:
• TANAKA Ayumi
  Tokyo 110-0016 (JP)
• NISHIKAWA Takeshi
  Tokyo 110-0016 (JP)
• FUKUGAMI Miki
  Tokyo 110-0016 (JP)

(74) Representative: Hoffmann Eitle
Patent- und Rechtsanwälte PartmbB
Arabellastraße 30
81925 München (DE)

(54) **GAS BARRIER LAYER FORMING COMPOSITION, GAS BARRIER FILM, PACKAGING FILM, AND PACKAGING BAG USING SAME, AND, GAS BARRIER FILM PRODUCTION METHOD, PACKAGING FILM PRODUCTION METHOD, AND PACKAGING BAG PRODUCTION METHOD**

(57)    A gas barrier layer-forming composition contains a solid content containing a polyurethane resin (A), a water-soluble polymer (B) and a curing agent (C). The polyurethane resin (A) contains a reaction product of an acid group-containing polyurethane resin having an acid group and a polyamine compound having an amino group. The polyurethane resin (A) content, the water-soluble polymer (B) content, and an inorganic layered mineral (D) content in the solid content are 45 mass% or more and 75 mass% or less, 20 mass% or more and 35 mass% or less, and less than 2 mass%, respectively.

FIG.1

## Description

[Technical Field]

The present disclosure relates to a gas barrier layer-forming composition, a gas barrier film, a packaging film and a packaging bag using the gas barrier layer-forming composition, and a method of producing a gas barrier film, a method of producing a packaging film and a method of producing a packaging bag.

[Background Art]

Packaging bags used for packaging food products or pharmaceutical products are required to have gas barrier properties for protecting the contents from moisture, oxygen and other gases that may degrade the contents, in order to protect the contents from degradation and decay and retain the functions and nature of the contents. For this reason, gas barrier films have been conventionally used for these packaging bags.

The gas barrier film typically includes a gas barrier layer on a first surface side of the resin substrate, and the gas barrier layer is formed by applying a gas barrier layer-forming composition capable of imparting a gas barrier function onto the first surface side of the resin substrate, and curing the applied composition.

Various films have been developed as these gas barrier films.

For example, PTL 1 discloses a gas barrier film in which a gas barrier layer is formed using, as a gas barrier layer-forming composition, a composition containing a solid content composed of a polyurethane resin, a water-soluble polymer, an inorganic layered mineral and a silane coupling agent.

[Citation List]

[Patent Literature]

PTL 1: JP 2017-222151 A

[Summary of the Invention]

[Technical Problem]

However, the gas barrier film described in PTL 1 has the following problems.

That is, the gas barrier film described in PTL 1 has room for improvement in simultaneously satisfying abuse resistance, lamination strength after retort treatment, and bloom suppressing effect. "Abuse resistance" refers to a capability of suppressing a decrease in at least one of the oxygen barrier properties and the water vapor barrier properties even after the Gelbo flex test (a test in which a gas barrier film is repeatedly subjected to compression while being twisted) is performed.

The present disclosure has been made in view of the above circumstances, and aims to provide a gas barrier layer-forming composition capable of imparting, when cured, excellent abuse resistance and high lamination strength even after applying retort treatment to a gas barrier film and suppressing occurrence of bleed-out. The present disclosure further aims to provide a gas barrier film, a packaging film and a packaging bag using the gas barrier layer-forming composition, and provide a method of producing a gas barrier film, a method of producing a packaging film and a method of producing a packaging bag.

[Solution to the Problem]

The present inventors conducted extensive research to solve the above problem and found that, in the gas barrier layer-forming composition containing a polyurethane resin, a water-soluble polymer and a curing agent such as a silane coupling agent, the content of an inorganic layered mineral, which is contained for imparting oxygen barrier properties and water vapor barrier properties, can be reduced whereby the gas barrier layer-forming composition, when cured, can impart high lamination strength even after applying retort treatment to the gas barrier film while imparting abuse resistance, and suppress occurrence of bleed-out. Therefore, the present inventors have further diligently studied in consideration of the respective contents of polyurethane resin and water-soluble polymer, and found that the above problems can be solved by the invention described below.

That is, the present disclosure is a gas barrier layer-forming composition containing a solid content containing: a polyurethane resin (A); a water-soluble polymer (B); and a curing agent (C), wherein the polyurethane resin (A) contains a reaction product of an acid group-containing polyurethane resin having an acid group and a polyamine compound having an amino group, and the polyurethane resin (A) content, the water-soluble polymer (B) content and an inorganic layered mineral (D) content in the solid content are 45 mass% or more and 75 mass% or less, 20 mass% or more and 35 mass% or less and less than 2 mass%, respectively.

The gas barrier layer-forming composition of the present disclosure, when cured, is capable of imparting excellent abuse resistance and high lamination strength even after applying retort treatment to a gas barrier film having a gas barrier layer composed of a cured product of the composition on a first surface side of a resin substrate, and suppressing occurrence of bleed-out.

As for the reason why the gas barrier layer-forming composition of the present disclosure can achieve the above effect, the present inventors consider it to be as follows.

That is, when the curing agent in the gas barrier layer-forming composition cures the gas barrier layer-forming composition, the curing agent is considered to be able to form a network by curing reactions with the polyurethane resin and water-soluble polymer in the gas barrier layer-forming composition while bonding with the layer adjacent to the gas barrier layer. By reducing the content of the inorganic layered mineral in the solid content, the curing agent can more easily bond with the layer adjacent to the gas barrier layer when it cures the gas barrier layer-forming composition, and the curing reactions with the polyurethane resin and water-soluble polymer in the gas barrier layer-forming composition are promoted, facilitating formation of a network. As a result, the gas barrier layer sufficiently adheres to the layer adjacent thereto and achieves excellent abuse resistance. Further, by avoiding providing too large a content of the curing agent, the curing agent can be retained in the composition. As a result, the present inventors presume that the gas barrier layer-forming composition of the present disclosure can achieve the above effect.

It is preferred that the inorganic layered mineral (D) content in the solid content is 0 mass%, and a total content of the polyurethane resin (A), the water-soluble polymer (B) and the curing agent (C) in the solid content is 100 mass%.

In this case, the gas barrier layer-forming composition, when cured, is capable of imparting high lamination strength even after applying retort treatment to the gas barrier film.

In the above gas barrier layer-forming composition, it is preferred that the curing agent (C) content in the solid content is 20 mass% or less.

In this case, the curing agent (C) is less likely to bleed out, suppressing contamination of the surface, compared with the case where the curing agent (C) content in the solid content exceeds 20 mass%.

In the above gas barrier layer-forming composition, it is preferred that the curing agent (C) content in the solid content is 5 mass% or more.

In this case, the composition, when cured, is capable of imparting higher lamination strength even after applying retort treatment to the gas barrier film compared with the case where the curing agent (C) content in the solid content is less than 5 mass%.

In the above gas barrier layer-forming composition, it is preferred that the water-soluble polymer (B) is polyvinyl alcohol or a modified product thereof.

The composition, when cured, is capable of imparting excellent gas barrier properties to the gas barrier film. Further, the composition, when cured, is capable of imparting excellent flexibility to the gas barrier film and impart excellent abuse resistance.

In the gas barrier layer-forming composition, it is preferred that the water-soluble polymer (B) has no silanol group.

In this case, the gas barrier layer can be provided with improved gas barrier properties compared with the case where the water-soluble polymer (B) has a silanol group.

In the gas barrier layer-forming composition, it is preferred that the curing agent (C) has an epoxy group.

In this case, the composition, when cured, is capable of having excellent hot water resistance and imparting high lamination strength even after applying retort treatment to the gas barrier film.

Furthermore, the present disclosure is a gas barrier film including: a resin substrate; and a gas barrier layer disposed on a first surface side of the resin substrate, the gas barrier layer being composed of a cured product of the above gas barrier layer-forming composition.

According to the gas barrier film, the gas barrier layer disposed on the first surface side of the resin substrate is composed of a cured product of the gas barrier layer-forming composition, and the gas barrier layer-forming composition, when cured, is capable of imparting excellent abuse resistance and high lamination strength even after applying retort treatment to the gas barrier film, and suppressing occurrence of bleed-out. Accordingly, the gas barrier film of the present disclosure can have excellent abuse resistance and high lamination strength even after retort treatment, and suppress occurrence of bleed-out.

In the above gas barrier film, it is preferred that the gas barrier layer ha a thickness of 800 nm or less.

In this case, the gas barrier film can be provided with improved flexibility and improved abuse resistance compared with the case where the thickness of the gas barrier layer exceeds 800 nm.

In the above gas barrier film, it is preferred that the gas barrier layer has a thickness of 150 nm or more.

In this case, the gas barrier film can be provided with improved gas barrier properties compared with the case where the thickness of the gas barrier layer is less than 150 nm.

It is preferred that the above gas barrier film further includes an inorganic oxide layer disposed between the resin substrate and the gas barrier layer, the inorganic oxide layer containing an inorganic oxide, and the inorganic oxide including an inorganic oxide composed of silicon oxide.

The gas barrier film can be provided with excellent water vapor barrier properties.

In the above gas barrier film, it is preferred that the inorganic oxide includes an inorganic oxide composed of silicon oxide.

The gas barrier film can be provided with further excellent water vapor barrier properties.

Furthermore, the present disclosure is a packaging film including: the above gas barrier film; and a sealant layer laminated on the gas barrier film.

According to the packaging film, the gas barrier film can have excellent abuse resistance and high lamination strength even after retort treatment, and suppress occurrence of bleed-out. Accordingly, the packaging film having the gas barrier film can also have excellent abuse resistance and high lamination strength even after retort treatment, and suppress occurrence of bleed-out. Since the packaging film includes the sealant layer, a packaging bag that can ensure sealing by bonding the sealant layers to each other can be easily produced.

Furthermore, the present disclosure is a packaging bag formed by using the above packaging film and bonding each of the sealant layer to the other.

The packaging bag is formed by using the packaging film and bonding the sealant layers to each other, and the packaging film includes the gas barrier film having excellent abuse resistance and high lamination strength even after retort treatment and capable of suppressing occurrence of bleed-out. Accordingly, the packaging bag of the present disclosure can have excellent abuse resistance and suppress occurrence of delamination even after retort treatment, and can also suppress occurrence of bleed-out. In addition, since the packaging bag is formed using the packaging film having the sealant layer, the packaging bag can ensure sufficient sealability.

Furthermore, the present disclosure is a method of producing a gas barrier film having a resin substrate and a gas barrier layer disposed on a first surface side of the resin substrate, the method including: a gas barrier layer forming step of forming the gas barrier layer by curing the above gas barrier layer-forming composition on a first surface side of the resin substrate to form a gas barrier film.

According to the above production method, in the gas barrier layer forming step, the gas barrier layer is formed by curing the above gas barrier layer-forming composition on the first surface side of the resin substrate to thereby produce the gas barrier film. In this step, the gas barrier layer-forming composition used in the gas barrier layer forming step, when cured, is capable of imparting excellent abuse resistance and high lamination strength even after applying retort treatment to the gas barrier film in which the gas barrier layer composed of a cured product of the composition is disposed on the first surface side of the resin substrate, and suppressing occurrence of bleed-out. Thus, according to the production method of the present disclosure, it is possible to produce a gas barrier film capable of having excellent abuse resistance and high lamination strength even after retort treatment and capable of suppressing occurrence of bleed-out.

Furthermore, the present disclosure is a method of producing a packaging film, the method including: a gas barrier film producing step of producing a gas barrier film by the above method of producing a gas barrier film; and a sealant layer lamination step of laminating a sealant layer on the gas barrier film to obtain a packaging film.

According to this production method, in the gas barrier film producing step, it is possible to produce a gas barrier film having excellent abuse resistance and high lamination strength even after retort treatment and capable of suppressing occurrence of bleed-out. Therefore, in the sealant layer lamination step, in which the sealant layer is laminated on the first surface side of the resin substrate of the gas barrier film, it is possible to produce a packaging film having excellent abuse resistance and high lamination strength even after retort treatment and capable of suppressing occurrence of bleed-out. Further, since the produced packaging film includes the sealant layer, a packaging bag that can ensure sealing by bonding the sealant layers to each other can be easily produced.

Furthermore, the present disclosure is a method of producing a packaging bag, the method including: a packaging film producing step of producing a packaging film by the above method of producing a packaging film; and a packaging film bonding step of using the packaging film and bonding each of the sealant layer to the other to produce a packaging bag.

According to this production method, in the packaging film producing step, it is possible to produce a packaging film having excellent abuse resistance and high lamination strength even after retort treatment and capable of suppressing occurrence of bleed-out. Therefore, in the packaging film bonding step, in which the packaging film is used and the sealant layers are bonded to each other, it is possible to produce a packaging bag capable of having excellent abuse resistance and suppressing occurrence of delamination even after retort treatment, and capable of suppressing occurrence of bleed-out. In addition, since the packaging bag is produced using the packaging film having the sealant layer by the production method according to the present disclosure, the produced packaging bag can ensure sufficient sealability.

[Advantageous Effects of the Invention]

The present disclosure provides a gas barrier layer-forming composition capable of, when cured, imparting excellent abuse resistance and high lamination strength even after applying retort treatment to a gas barrier film and suppressing occurrence of bleed-out, a gas barrier film, a packaging film and a packaging bag using the gas barrier layer-forming composition, and a method of producing a gas barrier film, a method of producing a packaging film and a method of producing a packaging bag.

[Brief Description of the Drawings]

Fig. 1 is a cross-sectional view illustrating an embodiment of a gas barrier film of the present disclosure.
Fig. 2 is a cross-sectional view illustrating an embodiment of a packaging film of the present disclosure.
Fig. 3 is a side view illustrating an embodiment of a packaging bag of the present disclosure.
Fig. 4 is a perspective view illustrating an example spouted packaging bag (gusset bag with a spout) to which the packaging bag of the present disclosure is applied.
Fig. 5 is a front view illustrating an example tube container to which the packaging film of the present disclosure is applied.

[Description of the Embodiments]

Some embodiments of the present disclosure will be described in detail below.

<Gas Barrier Layer-Forming Composition>

A gas barrier layer-forming composition contains a solid content containing a polyurethane resin (A), a water-soluble polymer (B) and a curing agent (C). The polyurethane resin (A) contains a reaction product of an acid group-containing polyurethane resin having an acid group and a polyamine compound having an amino group. The polyurethane resin (A) content, the water-soluble polymer (B) content, and an inorganic layered mineral (D) content in the solid content are 45 mass% or more and 75 mass% or less, 20 mass% or more and 35 mass% or less, and less than 2 mass%, respectively.

According to the gas barrier layer-forming composition of the present disclosure, the composition, when cured, is capable of imparting excellent abuse resistance and high lamination strength even after applying retort treatment to a gas barrier film having a gas barrier layer composed of a cured product of the composition on a first surface side of a resin substrate, and suppressing occurrence of bleed-out.

The following description will be given of the details of the gas barrier layer-forming composition.

(A) Polyurethane Resin

The polyurethane resin contains a reaction product of an acid group-containing polyurethane resin having an acid group and a polyamine compound having an amino group. In other words, the reaction product is formed by the union of an acid group-containing polyurethane resin having an acid group and a polyamine compound having an amino group, in which bonds are formed between the acid group of the acid group-containing polyurethane resin and the amino group of the polyamine compound.

The acid group of the acid group-containing polyurethane resin may be one that can be bonded to the amino group of the polyamine compound constituting the polyurethane resin (A), and examples of the acid group include a carboxy group and a sulfonic acid group.

Examples of the acid group-containing polyurethane resin include those having a structural unit containing a cyclic hydrocarbon and those having a structural unit containing a chain hydrocarbon.

Specific examples of the acid group-containing polyurethane resin include carboxylic acid-modified polyurethane resins, sulfonic acid-modified polyurethane resins, and the like. These can be used singly or in combination of two or more.

The amino group of the polyamine compound may be any of a primary amino group, a secondary amino group and a tertiary amino group.

Specific examples of the polyamine compound include alkylene diamines, polyalkylene polyamines, and the like. These can be used singly or in combination of two or more.

The bond between an acid group of the acid group-containing polyurethane resin and an amino group of the polyamine compound may be an ionic bond (for example, an ionic bond between a carboxyl group and a tertiary amino group), or may be a covalent bond (for example, an amide bond).

The number average molecular weight of the polyurethane resin (A) is not particularly limited, but is preferably 800 to 1,000,000. In this case, the viscosity of the gas barrier layer-forming composition can be reduced, facilitating application of the gas barrier layer-forming composition, compared with the case where the number average molecular weight of the polyurethane resin (A) exceeds 1,000,000. Further, the gas barrier film can be provided with more excellent gas barrier properties compared with the case where the number average molecular weight of the polyurethane resin (A) is less than 800. The number average molecular weight of the polyurethane resin (A) is a value in terms of standard polystyrene, as measured by gel permeation chromatography (GPC).

The number average molecular weight of the polyurethane resin (A) is more preferably 800 to 200,000, and still more preferably 800 to 100,000.

The polyurethane resin (A) content in the solid content is 45 mass% or more and 75 mass% or less. In this case, the composition, when cured, is capable of imparting higher lamination strength even after applying retort treatment to the gas barrier film compared with the case where the polyurethane resin (A) content in the solid content is less than 45 mass%. Also, the composition, when cured, is capable of imparting more excellent abuse resistance to the gas barrier film compared with the case where the polyurethane resin (A) content in the solid content exceeds 75 mass%.

The polyurethane resin (A) content in the solid content is preferably 47 mass% or more, more preferably 50 mass% or more, and particularly preferably 60 mass% or more.

The polyurethane resin (A) content in the solid content is preferably 74 mass% or less, more preferably 72 mass% or less, and particularly preferably 65 mass% or less.

(B) Water-Soluble Polymer

The water-soluble polymer (B) refers to a polymer that is soluble in water.

Specific examples of the water-soluble polymer (B) include polyvinyl alcohol resins, modified products thereof, polyacrylic acid, and the like. These can be used singly or in combination of two or more. In particular, a polyvinyl alcohol resin or a modified product thereof is preferred as the water-soluble polymer (B). In this case, the composition, when cured, is capable of imparting excellent gas barrier properties to the gas barrier film. Further, the composition, when cured, is capable of imparting excellent flexibility to the gas barrier film and impart excellent abuse resistance.

The polyvinyl alcohol resin is composed of a homopolymer of vinyl alcohol or a vinyl alcohol-vinyl acetate copolymer. A modified product of polyvinyl alcohol resin is a resin obtained by further introducing a structural unit derived from a monomer different from vinyl alcohol or vinyl acetate into a polyvinyl alcohol resin. Examples of such a monomer include monomers having a silanol group and monomers having a carboxy group.

The water-soluble polymer (B) is preferably a polyvinyl alcohol resin. In this case, the gas barrier layer can be provided with improved gas barrier properties compared with the case where the water-soluble polymer (B) is a modified product of a polyvinyl alcohol resin.

The water-soluble polymer (B) may or may not have a silanol group, but preferably does not have a silanol group.

In this case, the gas barrier layer can be provided with improved gas barrier properties compared with the case where the water-soluble polymer (B) has a silanol group.

When the water-soluble polymer (B) is composed of a polyvinyl alcohol resin or a modified product thereof, the degree of saponification of the water-soluble polymer (B) is not particularly limited, but is preferably 95% or more, or may be 100%, from the perspective of improving the gas barrier properties of the gas barrier film 10.

The degree of polymerization of the water-soluble polymer (B) is not particularly limited, but is preferably 300 or more, and more preferably 450 or more from the perspective of improving the gas barrier properties of the gas barrier film 10. The degree of polymerization of the water-soluble polymer (B) is preferably 2400 or less.

The water-soluble polymer (B) content in the solid content is 20 mass% or more and 35 mass% or less. In this case, the composition, when cured, is capable of imparting more excellent abuse resistance to the gas barrier film compared with the case where the water-soluble polymer (B) content in the solid content is less than 20 mass%. Also, the composition, when cured, is capable of imparting higher lamination strength even after applying retort treatment to the gas barrier film compared with the case where the water-soluble polymer (B) content in the solid content exceeds 35 mass%.

The water-soluble polymer (B) content in the solid content is preferably 20 mass% or more, more preferably 21 mass% or more, and particularly preferably 25 mass% or more.

The water-soluble polymer (B) content in the solid content is preferably 34 mass% or less, more preferably 33 mass% or less, and particularly preferably 32 mass% or less.

(C) Curing Agent

The curing agent (C) is not specifically limited as long as it is capable of curing the gas barrier layer-forming composition, and in particular, a silane coupling agent is preferably used as the curing agent (C) from the viewpoint that the composition, when cured, can impart high lamination strength even after applying retort treatment to the gas barrier film.

Examples of the silane coupling agent include compounds represented by the following general formula (1).

$$Si(OR^1)_p(R^2)_{3-p}R^3 \dots \qquad (1)$$

In the above general formula (2), $R^1$ represents an alkyl group such as a methyl group or an ethyl group, $R^2$ represents a monovalent organic group such as an alkyl group, an aralkyl group, an aryl group, an alkenyl group, an acryloxy group, or an alkyl group substituted with a methacryloxy group, $R^3$ represents a monovalent organic functional group, and p represents an integer of 1 to 3. When a plurality of $R^1$s or $R^2$s are present, the $R^1$s or the $R^2$s may be the same or different. The monovalent organic functional group represented by $R^3$ may be a vinyl group, an epoxy group, a mercapto group, an amino group or a monovalent organic functional group containing an isocyanate group. In particular, the monovalent organic functional group is preferably one containing an epoxy group. In this case, the composition, when cured, is capable of having excellent hot water resistance and imparting high lamination strength even after applying retort treatment to the gas barrier film.

Examples of the silane coupling agent include silane coupling agents having a vinyl group, such as vinyltrimethoxysilane and vinyltriethoxysilane; silane coupling agents having an epoxy group, such as 3-glycidoxypropyltrimethoxysilane, 3-glycidoxypropyltriethoxysilane, 3-glycidoxypropylmethyldimethoxysilane and 3-glycidoxypropyl ethyldiethoxysilane; silane coupling agents having a mercapto group, such as 3-mercaptopropyltrimethoxysilane and 3-mercaptopropylmethyldimethoxysilane; silane coupling agents having an amino group, such as 3-aminopropyltrimethoxysilane and 3-aminopropyltriethoxysilane; and silane coupling agents having an isocyanate group, such as 3-isocyanatepropyltriethoxysilane. These silane coupling agents may be used singly or in combination of two or more.

The curing agent (C) content in the solid content is not particularly limited as long as it is larger than 0 mass%.

The curing agent (C) content in the solid content is preferably 5 mass% or more, more preferably 7 mass% or more, and particularly preferably 8 mass% or more. In this case, the composition, when cured, is capable of imparting higher lamination strength even after applying retort treatment to the gas barrier film compared with the case where the curing agent (C) content in the solid content is less than 5 mass%.

The curing agent (C) content in the solid content is preferably 20 mass% or less, more preferably 15 mass% or less, and particularly preferably 13 mass% or less. In this case, the curing agent (C) is less likely to bleed out, suppressing contamination of the surface, compared with the case where the curing agent (C) content in the solid content exceeds 20 mass%.

(D) Inorganic Layered Mineral

The inorganic layered mineral (D) refers to an inorganic compound in which unit crystal layers are superposed to form a single layered particle.

Examples of the inorganic layered mineral (D) include hydrous silicates such as phyllosilicate minerals. Specific examples of the hydrous silicates include kaolinite clay minerals such as halloysite, kaolinite and endellite; antigorite clay minerals such as antigorite and chrysotile; smectite clay minerals such as montmorillonite and beidellite; vermiculite clay minerals such as vermiculite; and micas such as synthetic mica, muscovite and phlogopite. These can be used singly or in combination of two or more.

The inorganic layered mineral (D) content in the solid content is less than 2 mass%. In this case, the composition, when cured, is capable of imparting higher lamination strength to the gas barrier film compared with the case where the inorganic layered mineral (D) content in the solid content is 2 mass% or more.

The inorganic layered mineral (D) content in the solid content is preferably 1 mass% or less, more preferably 0.5 mass% or less, and particularly preferably 0.1 mass% or less. The inorganic layered mineral (D) content in the solid content may be 0 mass%.

(Other Components in Solid Content)

The solid content may also contain, as necessary, known additives such as an isocyanate compound, a dispersant, a stabilizer, a viscosity modifier and a colorant to an extent that does not impair the gas barrier properties of the gas barrier layer.

(Total Content of Components in Solid Content)

The total content of the polyurethane resin (A), the water-soluble polymer (B), the curing agent (C) and the inorganic layered mineral (D) in the solid content is not particularly limited, but is typically 95 mass% or more, preferably 97 mass% or more, and may also be 100 mass%.

When the inorganic layered mineral (D) content in the solid content is 0 mass%, the total content of the polyurethane resin (A), the water-soluble polymer (B) and the curing agent (C) in the solid content is preferably 100 mass%.

In this case, the gas barrier layer-forming composition, when cured, is capable of imparting high lamination strength to the gas barrier film.

(Liquid)

As liquid for dissolving or dispersing the above solid content, an aqueous medium is typically used. Examples of the aqueous medium include water, a hydrophilic organic solvent, and a mixture thereof. Examples of the hydrophilic organic solvent include alcohols such as methanol, ethanol and isopropanol; ketones such as acetone and methyl ethyl ketone; ethers such as tetrahydrofuran; cellosolves; carbitols; and nitriles such as acetonitrile. These can be used singly or in combination of two or more.

The aqueous medium is preferably an aqueous medium containing water only or an aqueous medium containing water as a main component. When the aqueous medium contains water as a main component, the water content in the aqueous medium is preferably 70 mass% or more, and more preferably 80 mass% or more.

<Gas Barrier Film>

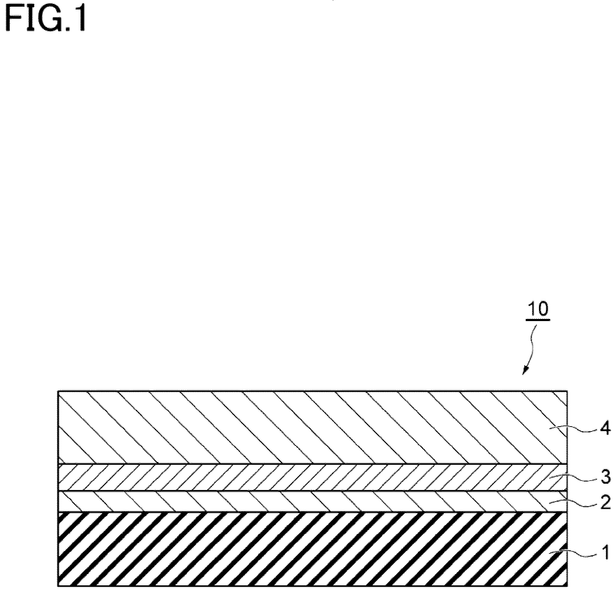

Fig. 1 is a cross-sectional view illustrating an embodiment of a gas barrier film of the present disclosure. In Fig. 1, the gas barrier film 10 includes a resin substrate 1, a gas barrier layer 4 disposed on a first surface side of the resin substrate 1, and a primer layer 2 and an inorganic oxide layer 3 disposed between the resin substrate 1 and the gas barrier layer 4 in this order from the resin substrate 1 side. The gas barrier layer 4 is composed of a cured product of the gas barrier layer-forming composition described above.

According to the gas barrier film 10, the gas barrier layer 4 disposed on the first surface side of the resin substrate 1 is composed of a cured product of the gas barrier layer-forming composition, and the gas barrier layer-forming composition, when cured, is capable of imparting excellent abuse resistance and high lamination strength even after applying retort treatment to the gas barrier film 10, and suppressing occurrence of bleed-out. Accordingly, the gas barrier film 10 can have excellent abuse resistance and high lamination strength even after retort treatment, and suppress occurrence of bleed-out.

The following description will be given of the details of the resin substrate 1, the primer layer 2, the inorganic oxide layer 3 and the gas barrier layer 4.

(Resin Substrate)

The resin substrate 1 is a substrate as a support of the gas barrier layer 4, and contains a resin. Examples of the resin include polyolefin resins, polyester resins, polyamide resins, polyether resins, acrylic resins, polyimide resins, epoxy resins and natural polymer compounds (cellulose acetate, and the like). These can be used singly or as a mixture of two or more.

In particular, polyolefin resins are preferably used from the viewpoint of recycling. The polyolefin resin may be polyethylene, polypropylene, or the like, but is preferably polypropylene from the viewpoint of retort treatment resistance. The polypropylene may be a homopolypropylene or a propylene copolymer, but from the viewpoint of oxygen barrier properties, a polypropylene copolymer is more preferably used for the polypropylene constituting at least a surface layer of the resin substrate 1 facing the gas barrier layer 4.

The resin substrate 1 may be a stretched film or a non-stretched film, but is preferably a non-stretched film from the viewpoint of oxygen barrier properties. The stretched film may be a uniaxially stretched film or a biaxially stretched film, but is preferably a biaxially stretched film since it improves thermal stability.

The thickness of the resin substrate 1 is not particularly limited, but may be, for example, 10 $\mu$m or more and 0.1 mm or less.

The resin substrate 1 may contain, if necessary, additives such as an antistatic agent, a UV absorber, a plasticizer, and a slip agent.

(Primer Layer)

The primer layer 2 is a layer for further enhancing adhesion between the resin substrate 1 and the inorganic oxide layer 3, and is disposed between the resin substrate 1 and the inorganic oxide layer 3.

The material constituting the primer layer 2 is not particularly limited as long as it is capable of enhancing adhesion between the resin substrate 1 and the inorganic oxide layer 3, and examples thereof include a reactant of an organosilane or an organometallic compound, a polyol compound and an isocyanate compound. That is, it can be said the primer layer 2 is a urethane-based adhesive layer. The organosilane may be, for example, trifunctional organosilane or a hydrolysate of trifunctional organosilane. The organometallic compound may be, for example, a metal alkoxide or a hydrolysate of metal alkoxide. A metal element contained in the organometallic compound may be, for example, Al, Ti, Zr, or the like. The hydrolysate of organosilane and the hydrolysate of metal alkoxide may each have at least one hydroxyl group. The polyol compound is preferably an acrylic polyol from the viewpoint of transparency. The isocyanate compound mainly functions as a crosslinking agent or a curing agent. The polyol compound and the isocyanate compound may be a monomer or a polymer.

The thickness of the primer layer 2 is not particularly limited as long as it is capable of enhancing adhesion between the resin substrate 1 and the inorganic oxide layer 3, but is preferably 30 nm or more. In this case, good adhesion is more likely to be obtained between the resin substrate 1 and the inorganic oxide layer 3 compared with the case where the thickness of the primer layer 2 is less than 30 nm. In addition, the primer layer 2 has further improved durability. The thickness of the primer layer 2 is preferably 30 nm or more, more preferably 35 nm or more, and still more preferably 40 nm or more. By increasing the thickness of the primer layer 2, a decrease in moisture barrier properties when an external force such as stretching is applied can be further suppressed. The thickness of the primer layer 2 is preferably less than 200 nm. In this case, cracking is less likely to occur in the primer layer 2 compared with the case where the thickness of the primer layer 2 is 200 nm or more.

(Inorganic Oxide Layer)

The inorganic oxide layer 3 is a layer containing an inorganic oxide. By providing the inorganic oxide layer 3, the gas barrier film 10 can be provided with excellent water vapor barrier properties.

Examples of the inorganic oxide include an oxide of Si, that is, silicon oxide (SiOx) and a metal oxide. Examples of the metal constituting the metal oxide include at least one kind of atom selected from the group consisting of Al, Mg, Sn, Ti and In. The inorganic oxide is preferably SiOx or AlOx from the viewpoint of water vapor barrier properties. In particular, SiOx is preferred as the inorganic oxide. In this case, the gas barrier film 10 can be provided with excellent water vapor barrier properties.

The inorganic oxide layer 3 may be composed of a single layer or multiple layers.

The thickness of the inorganic oxide layer 3 is not particularly limited, but is preferably 10 nm or more and 100 nm or less. In this case, the water vapor barrier properties of the gas barrier film 10 are more likely to improve compared with the case where the thickness of the inorganic oxide layer 3 is less than 10 nm. Further, cracking due to an increase in internal stress is less likely to occur, preventing the water vapor barrier properties from decreasing, compared with the case where the thickness of the inorganic oxide layer 3 exceeds 100 nm.

The thickness of the inorganic oxide layer 3 is more preferably 10 nm or more and 100 nm or less.

(Gas Barrier Layer)

The gas barrier layer 4 is composed of a cured product of the gas barrier layer-forming composition described above.

The thickness of the gas barrier layer 4 is not particularly limited, but is preferably 800 nm or less.

In this case, the gas barrier layer 4 can be provided with improved flexibility and improved abuse resistance compared with the case where the thickness of the gas barrier layer 4 exceeds 800 nm.

The thickness of the gas barrier layer 4 is more preferably 150 nm or more, and particularly preferably 180 nm or more from the perspective of improving the gas barrier properties. In this case, the gas barrier layer 4 can be provided with improved gas barrier properties compared with the case where the thickness of the gas barrier layer 4 is less than 150 nm.

The thickness of the gas barrier layer 4 is more preferably 750 nm or less, and particularly preferably 500 nm or less from the perspective of improving the abuse resistance.

<Method of Producing Gas Barrier Film>

Next, a method of producing a gas barrier film 10 will be described.

First, a resin substrate 1 is provided.

Next, a primer layer 2 is formed on a first surface of the resin substrate 1.

Specifically, a primer layer 2 can be formed by, for example, applying a composition containing an organosilane or an organometallic compound, a polyol compound and an isocyanate compound to the first surface of the resin substrate 1, heating and drying the applied composition. The heating temperature may be, for example, 50 to 200°C, and the heating time may be, for example, about 10 seconds to 10 minutes.

Next, an inorganic oxide layer 3 is formed on the primer layer 2.

The inorganic oxide layer 3 can be formed by, for example, vacuum deposition. The vacuum deposition may be physical vapor deposition or chemical vapor deposition. Examples of the physical vapor deposition include vacuum deposition, sputtering deposition, ion plating, and the like. In particular, vacuum deposition is preferably used as the physical vapor deposition. Examples of the vacuum deposition include resistance heating vacuum deposition, EB (Electron Beam) heating vacuum deposition and induction heating vacuum deposition. Further, examples of the chemical vapor deposition include thermal CVD, plasma CVD, photo CVD, and the like.

Next, a gas barrier layer 4 is formed on the inorganic oxide layer 3 (gas barrier layer forming step).

The gas barrier layer 4 can be formed by, for example, applying a gas barrier layer-forming composition on a side of the inorganic oxide layer 3 opposite to that having the primer layer 2, and curing the applied composition. Here, curing of the solid content means that the polyurethane resin (A), the water-soluble polymer (B) and the curing agent (C) in the solid content react and integrate with each other.

The gas barrier layer-forming composition can be applied by a known method. Specific examples of the method include wet film-forming methods such as gravure coating, dip coating, reverse coating, wire bar coating, die coating, and the like.

Curing can be performed, for example, by heating.

When curing is performed by heating, the heating temperature and heating time may be set so that the solid content in the gas barrier layer-forming composition is cured while the liquid such as an aqueous medium is removed. The heating temperature may be, for example, 80°C to 250°C, and the heating time may be, for example, 3 seconds to 10 minutes.

Thus, production of a gas barrier film 10 is completed.

According to the above production method, in the gas barrier layer forming step, the gas barrier layer 4 is formed by curing the gas barrier layer-forming composition described above on the first surface side of the resin substrate 1 to thereby produce the gas barrier film 10. In this step, the gas barrier layer-forming composition used in the gas barrier layer forming step, when cured, is capable of imparting excellent abuse resistance and high lamination strength even after applying retort treatment to the gas barrier film 10 in which the gas barrier layer 4 composed of a cured product of the composition is disposed on the first surface side of the resin substrate 1, and suppressing occurrence of bleed-out. Thus, according to the production method of the present disclosure, it is possible to produce a gas barrier film 10 capable of having excellent abuse resistance and high lamination strength even after retort treatment and capable of suppressing occurrence of bleed-out.

<Packaging Film>

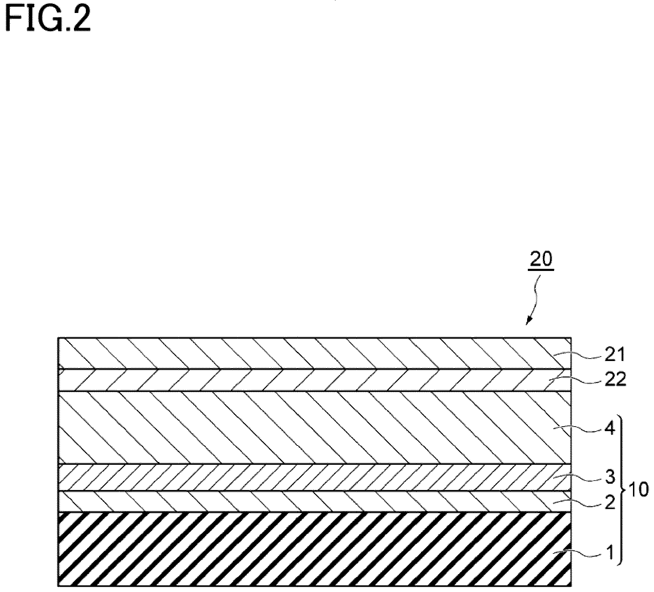

Next, an embodiment of the packaging film of the present disclosure will be described with reference to Fig. 2. In Fig. 2, the same components as those in Fig. 1 are denoted by the same reference signs, and repeated description is omitted.

Fig. 2 is a cross-sectional view illustrating an embodiment of a packaging film of the present disclosure. As shown in Fig. 2, the packaging film 20 includes the gas barrier film 10 and a sealant layer 21 laminated on the gas barrier film 10. The sealant layer 21 is disposed on the first surface side of the resin substrate 1 of the gas barrier film 10. In Fig. 2, the gas barrier layer 4 of the gas barrier film 10 and the sealant layer 21 are adhered to each other via an adhesive layer 22.

According to the packaging film 20, the gas barrier film 10 can have excellent abuse resistance and high lamination strength even after retort treatment, and suppress occurrence of bleed-out. Accordingly, the packaging film 20 having the gas barrier film 10 can also have excellent abuse resistance and high lamination strength even after retort treatment, and suppress occurrence of bleed-out. Since the packaging film 20 includes the sealant layer 21, a packaging bag that can ensure sealing by bonding the sealant layers 21 to each other can be easily produced.

The adhesive layer 22 can be made of, for example, polyester-isocyanate-based resin, urethane resin, polyether-based resin, or the like. When the packaging film 20 is used for retort applications, two-part curing type urethane-based adhesive having retort treatment resistance can be preferably used.

(Sealant Layer)

Examples of the material of the sealant layer 21 include thermoplastic resins such as polyolefin resins and polyester resins, but polyolefin resins are typically used. Specifically, examples of the polyolefin resins include ethylene-based resins such as low-density polyethylene resin (LDPE), medium-density polyethylene resin (MDPE), linear low-density polyethylene resin (LLDPE), ethylene-vinyl acetate copolymer (EVA), ethylene-$\alpha$-olefin copolymer and ethylene-methacrylic acid resin copolymer, polypropylene-based resins such as homopolypropylene resin (PP), propylene-ethylene random copolymer, propylene-ethylene block copolymer and propylene-$\alpha$-olefin copolymer, and mixtures thereof. The material of the sealant layer 21 can be appropriately selected from the thermoplastic resins described above depending on the intended use and temperature conditions of boiling treatment, retort treatment, and the like.

The thickness of the sealant layer 21 is appropriately determined by the mass of the contents, the shape of the packaging bag, and the like, but is preferably 30 $\mu$m to 150 $\mu$m, and more preferably 50 $\mu$m to 100 $\mu$m from the viewpoint of the flexibility and adhesiveness of the packaging film 20.

<Method of Producing Packaging Film>

Next, a method of producing a packaging film 20 will be described.

First, the gas barrier film 10 is produced by the above method of producing a gas barrier film (gas barrier film producing step).

Next, the sealant layer 21 is laminated and adhered to the first surface side of the resin substrate 1 of the gas barrier film 10 via the adhesive layer 22 to obtain a packaging film 20 (sealant layer lamination step).

According to this production method, in the gas barrier film producing step, it is possible to produce a gas barrier film 10 having excellent abuse resistance and high lamination strength even after retort treatment and capable of suppressing occurrence of bleed-out. Therefore, in the sealant layer lamination step, in which the sealant layer 21 is laminated on the first surface side of the resin substrate 1 of the gas barrier film 10, it is possible to produce a packaging film 20 having excellent abuse resistance and high lamination strength even after retort treatment and capable of suppressing occurrence of bleed-out. Further, since the produced packaging film 20 includes the sealant layer 21, it is possible to easily produce a packaging bag that can ensure sealing by bonding the sealant layers 21 of the produced packaging film 20 to each other.

Although the packaging film 20 includes the adhesive layer 22, the adhesive layer 22 may be omitted when the sealant layer 21 is made of the above thermoplastic resin and capable of adhering to the gas barrier layer 4 of the gas barrier film 10 by heat sealing. In this case, the sealant layer 21 can be bonded to the resin substrate 1 by extrusion lamination or the like in which the above gas barrier film 10 is heated and melted, and then extruded in a curtain shape to be bonded.

<Packaging Bag>

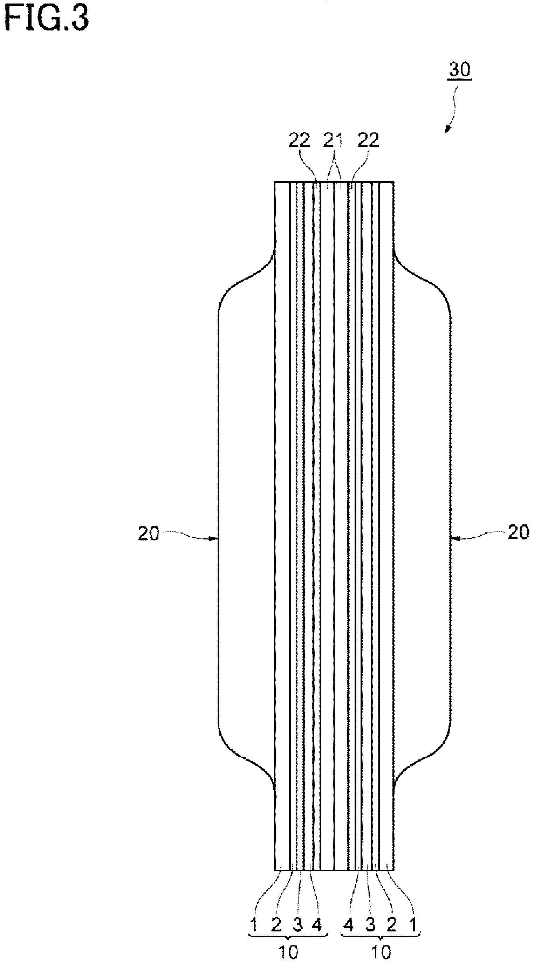

Next, an embodiment of the packaging bag of the present disclosure will be described with reference to Fig. 3. In Fig. 3, the same components as those in Fig. 1 or 2 are denoted by the same reference signs, and repeated description is omitted.

Fig. 3 is a side view illustrating an embodiment of a packaging bag of the present disclosure. As shown in Fig. 3, the packaging bag 30 is formed by using the packaging film 20 and bonding the sealant layers 21 to each other.

The packaging bag 30 is formed by using the packaging film 20 and bonding the sealant layers 21 to each other, and the packaging film 20 includes the gas barrier film 10 having excellent abuse resistance and high lamination strength even after retort treatment and capable of suppressing occurrence of bleed-out. Accordingly, the packaging bag 30 can have excellent abuse resistance and suppress occurrence of delamination even after retort treatment, and can also suppress occurrence of bleed-out. In addition, since the packaging bag 30 is formed using the packaging film 20 having the sealant layer 21, the packaging bag 30 can ensure sufficient sealability.

<Method of Producing Packaging Bag>

Next, a method of producing a packaging bag 30 will be described.

First, the packaging film 20 is produced by the above method of producing the packaging film 20 (packaging film producing step).

Next, using the packaging film 20, the sealant layers 21 are bonded to each other while forming an aperture to thereby obtain a bonded body. After contents such as food products or pharmaceutical products are introduced through the aperture of the bonded body, the aperture of the bonded body is sealed to thereby produce a packaging bag 30 (packaging film bonding step).

According to this production method, in the packaging film producing step, it is possible to produce a packaging film 20 having excellent abuse resistance and high lamination strength even after retort treatment and capable of suppressing occurrence of bleed-out. Therefore, in the packaging film bonding step, in which the packaging film 20 is used and the sealant layers 21 are bonded to each other, it is possible to produce a packaging bag 30 capable of having excellent abuse resistance and suppressing occurrence of delamination even after retort treatment, and capable of suppressing occurrence of bleed-out. In addition, since the packaging bag 30 is produced using the packaging film 20 having the sealant layer 21 by the above method of producing a packaging bag, the produced packaging bag 30 can ensure sufficient sealability.

In the above packaging film bonding step, the above bonded body can be formed by folding a single sheet of the packaging film 20 with the sealant layers 21 facing each other, and then heat-sealing the peripheral portions of the sealant layers 21 facing each other, or by overlapping two sheets of the packaging film 20 with the sealant layers 21 facing each other, and then heat-sealing the peripheral portions of the sealant layers 21 facing each other.

In the above packaging film bonding step, the contents are not necessarily contained in the bonded body. In this case, the packaging bag refers to the bonded body having an aperture.

The present disclosure is not limited to the embodiment described above. For example, in the above embodiment, the gas barrier film 10 includes the primer layer 2 and the inorganic oxide layer 3. However, at least one of the primer layer 2 and the inorganic oxide layer 3 can be omitted.

Further, in the above embodiment, the sealant layer 21 is disposed on the first surface side (gas barrier layer 4 side) of the resin substrate 1 of the gas barrier film 10 in the packaging film 20. However, the sealant layer 21 may be disposed on a second surface side (on a side facing away from the gas barrier layer 4) of the resin substrate 1, or may be disposed on the first surface side and the second surface side of the resin substrate 1.

Furthermore, the packaging bag of the present disclosure can be used as a packaging bag of a spouted packaging bag. The spouted packaging bag may have a structure in which a spout is sandwiched and fixed between two packaging films constituting the packaging bag, or a structure in which an opening is formed in one wall of the packaging bag and a pouring spout is adhered and fixed thereto. The pouring spout may be provided on the top of the packaging bag, the upper corner of the packaging bag, or the side or bottom of the packaging bag. When the contents contained in the packaging bag are liquid or gel-like foods, a straw reaching the bottom of the packaging bag may be provided in the packaging bag in addition to the pouring spout (spout assembly) so that the user can directly suck on the spout to suck out the contents.

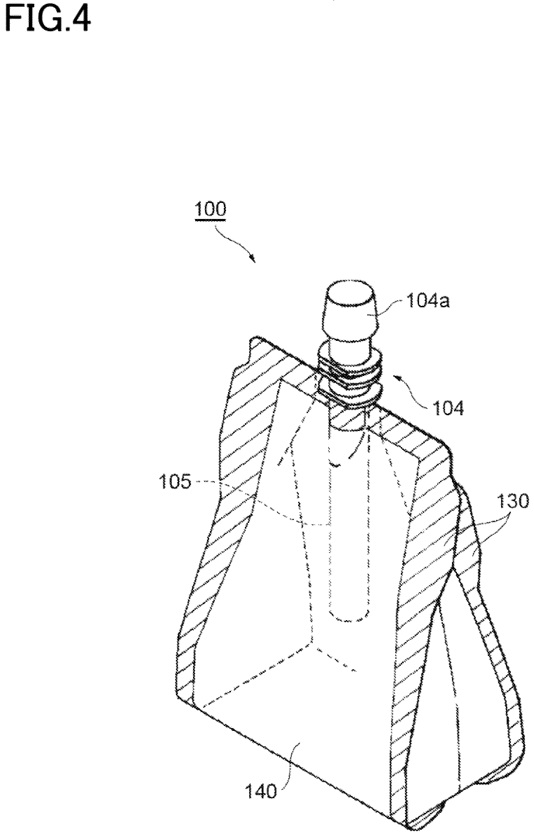

Fig. 4 is a perspective view illustrating an example spouted packaging bag (gusset bag with a spout) to which the packaging bag of the present disclosure is applied. A spouted packaging bag 100 shown in Fig. 4 has a structure in which a spout 104 is sandwiched between packaging films constituting a packaging bag 140 and fixed to a sealed portion 130, and the spout 104 is provided with a straw 105 reaching the bottom of the packaging bag 140. Further, the spouted packaging bag 100 is configured to seal the packaging bag 140 by closing a spout cap 104a. The packaging bag 140 constituting the spouted packaging bag 100 may be a gusset bag that is able to stand alone due to the lower part being configured to expand and bulge when the bag is filled with the contents.

Furthermore, the packaging film of the present disclosure can be suitably used as a squeeze pouch. The squeeze pouch may be provided with a resealable spout, or may be configured as a single-use pouch in which a pouring spout is formed by tearing off the pouch.

The packaging film of the present disclosure can be used as a bag for a bag-in-box, particularly as a main body of a bag having a pouring spout (tube). The bag-in-box includes a bag (inner bag) and a carton (outer box) accommodating the bag, and the bag contains a liquid such as a soft drink or an alcoholic drink.

In the case of any of the spouted packaging bags described above, it is preferred that the spout portion or the entire spout including the cap is made of the same resin as that of the resin substrate of the packaging film and the resin contained in the gas barrier layer from the perspective of improving recyclability.

Further, the packaging film of the present disclosure can be used as a body of a tube container. The tube container typically includes a body formed of the packaging film and a spout unit prepared by extrusion molding. The spout unit is composed of a nozzle for discharging the contents and a shoulder for guiding the contents held in the body to the nozzle.

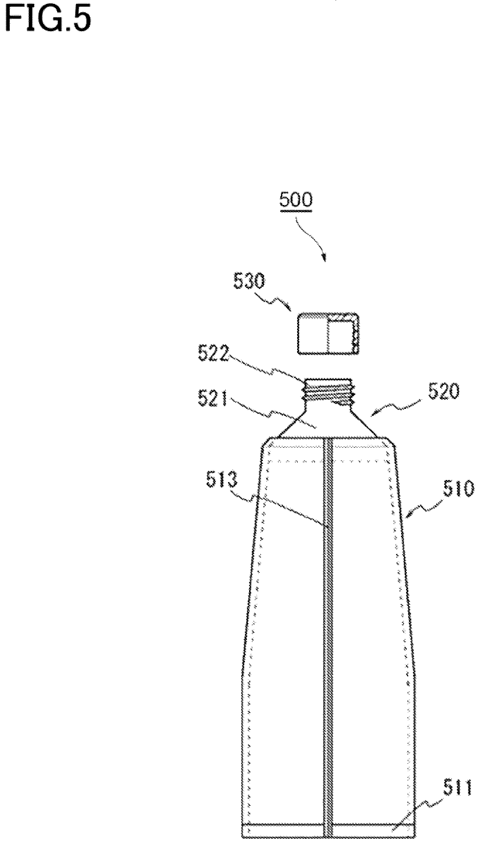

Fig. 5 is a front view illustrating an example tube container to which the packaging film of the present disclosure is applied. A tube container 500 shown in Fig. 5 includes a body 510 formed of a packaging film, a spout unit 520 attached to a first end of the body 510, and a cap 530 detachably attached to the spout unit 520. The body 510 is a tubular member formed by bonding the sealant layers of the packaging film to each other at a sealed portion 513 and closing a bottom 511 located on a second end on a side opposite to the first end to which the spout unit 520 is attached, so that the body 510 can contain the contents. The spout unit 520 is composed of a nozzle 522 for discharging the contents and a shoulder 521 for guiding the contents held in the body 510 to the nozzle 522. The cap 530 is a member that enables opening and closing of the nozzle 522.

Since the packaging film of the present disclosure has gas barrier properties and excellent abuse resistance, it is suitable for use as the body of the tube container described above which is repeatedly subjected to bending or folding to squeeze out the contents. The packaging film of the present disclosure can also be used as a body of a laminate tube, which is a type of the tube container. The body of the laminate tube may have a layer configuration which includes, from the innermost layer, a first resin layer (sealant layer), an adhesive layer, a gas barrier layer, a resin substrate, an adhesive layer and a second resin layer (sealant layer), or alternatively, a layer configuration which includes, from the innermost layer, a second resin layer (sealant layer), an adhesive layer, a resin substrate, a gas barrier layer, an adhesive layer and a first resin layer (sealant layer). Here, it is also possible to provide an inorganic oxide layer and an undercoat layer, in this order from the gas barrier layer side, between the gas barrier layer and the resin substrate.

A print layer may be provided on a first surface of the second resin layer and bonded to the resin substrate with the adhesive layer interposed therebetween, or may be provided on a first surface of the first resin layer and bonded to the resin substrate with the adhesive layer and the gas barrier layer interposed therebetween. Alternatively, the body of the tube container may have a configuration in which the first or second resin layer on the outermost side is not a sealant layer but is the same resin layer as the resin substrate which is not intended for heat sealing, and may be formed into a tubular shape by bonding the sealant layers on the innermost side to each other at the end (sealed portion) of the packaging film. In this case, in which the outermost layer does not need to be a sealant layer, high density polyethylene or polypropylene resin can be selected as a material of the outermost layer, enhancing the durability and aesthetic properties of the tube container.

Further, since a sealant layer typically requires a thickness of 60 µm to 100 µm, the amount of plastic used in the entire tube container can be greatly reduced if a resin substrate (approximately 20 µm to 30 µm in thickness), instead of a sealant layer, can be used as the outermost layer. In a layer configuration in which the first resin layer on the innermost side is a sealant layer, the amount of plastic used in the entire tube container can be further reduced by using the resin substrate as the outermost layer and providing no second resin layer. In this case, a print layer may be formed on the resin substrate on the outermost side and protected by an overprint varnish.

In a tube container having no sealant layer on the outermost side, a laminate constituting the body has a thickness smaller than that of a tube container having a sealant layer on both sides of the laminate. Accordingly, the stress applied to the gas barrier layer due to bending might seem to be relatively large. However, the packaging film of the present disclosure, which has gas barrier properties and excellent abuse resistance, can be suitably used for a tube container having no sealant layer on the outermost side.

For the shape of the tube container, the shoulder portion may be provided perpendicularly to the extending direction of the body without providing a taper to the body portion, so that the contents can be completely squeezed out. In the packaging film, the resin substrate and the sealant layer of can be made of the same resin to improve the recyclability. The material of the spout unit and the cap of the tube container is not particularly limited, but when it is the same resin as that of the resin substrate, the recyclability can be further improved. In order to prevent a tube container from being tampered with, an easy peel sealant film that closes the opening of the nozzle from the outside may be provided. The packaging film of the present disclosure can also be used as a sealing lid for the opening in combination with an easy peel sealant film.

Examples

The present disclosure will be described in detail below by using examples, but the present disclosure should not be limited to the following examples.

<Preparation of Coating Solution>

Coating solutions 1 to 14 as gas barrier layer-forming compositions used in the examples and comparative examples are prepared as follows.

(Coating Solution 1)

An aqueous dispersion of a polyurethane resin (A1) as an aqueous dispersion of the polyurethane resin (A), an aqueous solution containing polyacrylic acid (PAA) as the water-soluble polymer (WSP), and epoxysilane as the curing agent (CA) were mixed so that the mass ratio (PU:WSP:CA:IM) of the polyurethane resin (PU) as the polyurethane resin (A), PAA, epoxysilane, and inorganic layered mineral (IM), as solid contents, became 60:25:15:0, and diluted with water and isopropanol so that the solid content concentration became 5 mass%. At this time, the isopropanol content in the entire solution was adjusted to 10 mass%. Thus, a coating solution 1 was prepared.

(Coating Solution 2)

A coating solution 2 was prepared in the same manner as the coating solution 1 except that the PAA aqueous solution was changed to polyvinyl alcohol (PVA) aqueous solution, and the epoxysilane was changed to aminosilane.

(Coating Solution 3)

A coating solution 3 was prepared in the same manner as the coating solution 1 except that the PAA aqueous solution was changed to PVA aqueous solution.

(Coating Solution 4)

A coating solution 4 was prepared in the same manner as the coating solution 1 except that the PAA aqueous solution was changed to PVA aqueous solution, and the mass ratio (PU:WSP:CA:IM) of the polyurethane resin, PVA, epoxysilane and inorganic layered mineral, as solid contents, became 75:20:5:0.

(Coating Solution 5)

A coating solution 5 was prepared in the same manner as the coating solution 1 except that the PAA aqueous solution was changed to PVA aqueous solution, and the mass ratio (PU:WSP:CA:IM) of the polyurethane resin, PVA, epoxysilane and inorganic layered mineral, as solid contents, became 45:35:20:0.

(Coating Solution 6)

A coating solution 6 was prepared in the same manner as the coating solution 1 except that the PAA aqueous solution and the epoxysilane were not used, and the mass ratio (PU:WSP:CA:IM) of the polyurethane resin, PAA, epoxysilane and inorganic layered mineral, as solid contents, became 100:0:0:0.

(Coating Solution 7)

A coating solution 7 was prepared in the same manner as the coating solution 1 except that the PAA aqueous solution was changed to PVA aqueous solution, the aqueous dispersion of the polyurethane resin and the epoxysilane were not used, and the mass ratio (PU:WSP:CA:IM) of the polyurethane resin, PVA, epoxysilane and inorganic layered mineral, as solid contents, became 0:100:0:0.

(Coating Solution 8)

A coating solution 8 was prepared in the same manner as the coating solution 1 except that the PAA aqueous solution was changed to PVA aqueous solution, the epoxysilane was not used, and the mass ratio (PU:WSP:CA:IM) of the polyurethane resin, PVA, epoxysilane and inorganic layered mineral, as solid contents, became 65:35:0:0.

(Coating Solution 9)

A coating solution 9 was prepared in the same manner as the coating solution 1 except that the PAA aqueous solution was changed to PVA aqueous solution, and the mass ratio (PU:WSP:CA:IM) of the polyurethane resin, PVA, epoxysilane and inorganic layered mineral, as solid contents, became 75:15:10:0.

(Coating Solution 10)

A coating solution 10 was prepared in the same manner as the coating solution 1 except that the PAA aqueous solution was changed to PVA aqueous solution, and the mass ratio (PU:WSP:CA:IM) of the polyurethane resin, PVA, epoxysilane and inorganic layered mineral, as solid contents, became 55:40:5:0.

(Coating Solution 11)

A coating solution 11 was prepared in the same manner as the coating solution 1 except that the PAA aqueous solution was changed to PVA aqueous solution, and the mass ratio (PU:WSP:CA:IM) of the polyurethane resin, PVA, epoxysilane and inorganic layered mineral, as solid contents, became 80:20:0:0.

(Coating Solution 12)

A coating solution 12 was prepared in the same manner as the coating solution 1 except that the PAA aqueous solution was changed to PVA aqueous solution, and the mass ratio (PU:WSP:CA:IM) of the polyurethane resin, PVA, epoxysilane and inorganic layered mineral, as solid contents, became 60:25:10:5.

(Coating Solution 13)

A coating solution 13 was prepared in the same manner as the coating solution 1 except that the PAA aqueous solution was changed to PVA aqueous solution, and the mass ratio (PU:WSP:CA:IM) of the polyurethane resin, PVA, epoxysilane and inorganic layered mineral, as solid contents, became 60:25:14:1.

(Coating Solution 14)

A coating solution 14 was prepared in the same manner as the coating solution 1 except that the PAA aqueous solution was changed to PVA aqueous solution, the "aqueous dispersion of the polyurethane resin (A)" was changed from the "aqueous dispersion of the polyurethane resin (A1)" to an "aqueous dispersion of a polyurethane resin (A2)", and the mass ratio (PU:WSP:CA:IM) of the polyurethane resin, PVA, epoxysilane and inorganic layered mineral, as solid contents, became 60:25:15:0.

As the above aqueous dispersion of the polyurethane resin (A), the water-soluble polymer (B), the curing agent (C) and the inorganic layered mineral (D), the following materials were specifically used.

(Aqueous Dispersion of Polyurethane Resin (A))

Aqueous Dispersion of Polyurethane Resin (A1)

An aqueous dispersion of a polyurethane resin in which a solid content (polyurethane resin (A1)) is dispersed in an aqueous medium composed of water (aqueous polyurethane dispersion, trade name "TAKELAC (registered trademark) WPB-341", manufactured by Mitsui Chemicals, Inc., solid content concentration: 30 mass%, polyurethane resin (A1): reaction product of acid group-containing polyurethane resin and polyamine compound)

Aqueous Dispersion of Polyurethane Resin (A2)

An aqueous dispersion of a polyurethane resin in which a solid content (polyurethane resin (A2)) is dispersed in an aqueous medium composed of water (trade name "HYDRAN HW350", manufactured by DIC corporation, solid content concentration: 30 mass%, polyurethane resin (A2): polyurethane resin that does not correspond to a reaction product of acid group-containing polyurethane resin and polyamine compound (polyester polyurethane resin))

(B) Water-Soluble Polymer

(B1) Polyvinyl Alcohol (PVA) Aqueous Solution

An aqueous solution of polyvinyl alcohol with a degree of saponification of 98 to 99% and a degree of polymerization of 500 (trade name "POVAL PVA-124", manufactured by Kuraray Co., Ltd., solid content concentration: 5 mass%)

(B2) Polyacrylic acid (PAA) Aqueous Solution

An aqueous solution of polyacrylic acid (trade name "ARON A-10H", manufactured by Toagosei Co., Ltd., solid content concentration: 25 mass%)

(C) Curing Agent

(C1) Aminosilane

N-2-(aminoethyl)-3-aminopropyl methyltrimethoxysilane (trade name "KBM-603", manufactured by Shin-Etsu Chemical Co., Ltd.)

(C2) Epoxysilane

3-glycidoxypropyltrimethoxysilane (trade name "KBM-403", manufactured by Shin-Etsu Chemical Co., Ltd.)

(D) Inorganic Layered Mineral

Synthetic mica (trade name "SOMACIF (registered trademark) MEB-3", manufactured by Katakura & Co-op Agri Corporation)

<Preparation of Primer Layer-Forming Composition>

The primer layer-forming composition was formed as below.

Acrylic polyol and tolylene diisocyanate were mixed so that the number of NCO groups of the tolylene diisocyanate was equivalent to the number of OH groups of the acrylic polyol, and then the mixture was diluted with ethyl acetate so that the total solid content (total amount of acrylic polyol and tolylene diisocyanate) was 5 mass%. Further, β-(3,4-epoxycyclohexyl)trimethoxysilane, in an amount of 5 parts by mass relative to 100 parts by mass of the total amount of acrylic polyol and tolylene diisocyanate, was added to the diluted mixture and mixed to prepare a primer layer-forming composition (anchor coat agent).

<Preparation of Gas Barrier Film>

(Example 1)

A gas barrier film was produced by a roll-to-roll process in the following manner. First, a polypropylene resin layer (trade name "U-1", biaxially stretched film, manufactured by Mitsui Chemicals Tohcello, Inc.) as a 20 μm thick resin substrate was mounted on an unwinding device, a conveying device and a winding device.

Next, the primer layer-forming composition prepared as described above was applied to a first surface of the resin substrate being conveyed by gravure coating to form a coating film. The coating film was heated at 120°C for 10 seconds and dried to form a 40 nm thick primer layer to thereby obtain a laminate. The laminate thus obtained was wound by the winding device to obtain a rolled laminate.

Next, the rolled laminate was mounted on the unwinding device, the conveying device and the winding device. Then, the laminate was fed out from the rolled laminate, and an AlOx film (inorganic oxide layer) was formed at a film thickness of 50 nm on the primer layer of the laminate being conveyed. The AlOx film was formed by introducing oxygen at a pressure of $1.2 \times 10^{-2}$ Pa while evaporating an aluminum ingot by electron beam heating using an electron-beam heating type vacuum deposition device.

The coating solution 1 was applied onto the AlOx film, followed by heating and drying, to form a gas barrier layer having a thickness of 400 nm as shown in Table 1. The heating was performed so that the liquid in the coating solution 1 was removed while the polyurethane resin, PAA and epoxysilane constituting the solid content in the coating solution 1 were cured to form a cured product. Specifically, the heating temperature was 60°C.

As described above, a gas barrier film was obtained in which the resin substrate, the primer layer, the inorganic oxide layer and the gas barrier layer were laminated in this order.

(Examples 2 to 11 and Comparative Examples 1 to 8)

A gas barrier film was prepared in the same manner as in Example 1 except that the resin substrate was composed of the material shown in Table 1 or 2, the inorganic oxide layer was composed of the metal oxide shown in Table 1 or 2, the gas barrier layer was formed using the coating solution shown in Table 1 or 2, and the gas barrier layer was formed at the thickness shown in Table 1 or 2. When the inorganic oxide layer is composed of SiOx, silicon dioxide was used as a SiO vapor deposition material instead of the aluminum ingot evaporated by electron beam heating. In Example 10, a 12 μm thick polyethylene terephthalate resin (PET) was used as the resin substrate.

<Evaluation of Gas Barrier Film>

The gas barrier films in Examples 1 to 11 and Comparative Examples 1 to 8 were examined to evaluate oxygen barrier properties and water vapor barrier properties after retort treatment, abuse resistance, and lamination strength even after retort treatment.

(Preparation of Laminate Film)

First, in order to perform these evaluations, laminate films were prepared in the following manner.

That is, a 60 μm thick unstretched polypropylene film (CPP, trade name "Torayfan ZK207", manufactured by Toray Advanced Film Co., Ltd.,) was bonded to a surface of the resin substrate of each gas barrier film obtained in Examples 1 to 11 and Comparative Examples 1 to 8 using a two-part type adhesive (trade name "A-525/A-52", manufactured by Mitsui Chemicals) to thereby obtain a laminate film.

(1) Evaluation of Oxygen Barrier Properties and Water Vapor Barrier Properties After Retort Treatment

(Preparation of Test Sample)

For evaluation of oxygen barrier properties and water vapor barrier properties after retort treatment, test samples were prepared as below.

First, using the laminate film prepared as described above, a three-sided seal pouch having an aperture was prepared. Here, the laminate film was folded with the unstretched polypropylene films face-to face, and the unstretched polypropylene films were sealed to each other to form a three-sided seal pouch. Then, tap water was introduced into the three-sided seal pouch through the aperture, which was then sealed to form a sealed body. The sealed body was subjected to heat treatment (retort treatment) at 121°C for 30 minutes. Thus, a test sample was prepared.

(Measurement of Oxygen Transmittance Rate)

The oxygen transmission rate (unit: cc/m$^2$·day·atm) of the above test samples was measured using an oxygen transmission rate measurement device (trade name: "OX-TRAN 2/20", manufactured by MOCON Inc.) under the conditions of a temperature of 30°C and a relative humidity of 70%. The measurement was performed according to JIS K-7126-2. Tables 1 and 2 show the results. Comparative Example 7, in which delamination was observed in the test sample and oxygen transmission rate could not be measured, was indicated as "not measurable" in Table 2.

(Measurement of Water Vapor Transmission Rate)

The water vapor transmission rate (unit: g/m$^2$·day) of the above test samples was measured using a water vapor transmission rate measurement device (trade name "PERMATRAN 3/31", manufactured by MOCON Inc.) under the conditions of a temperature of 40°C and a relative humidity of 90%. The measurement was performed according to JIS K-7129. Tables 1 and 2 show the results. Comparative Example 7, in which delamination was observed in the test sample and water vapor transmission rate could not be measured, was indicated as "not measurable" in Table 2.

(Evaluation of Oxygen Barrier Properties)

The oxygen barrier properties of the above test samples were evaluated according to the following criteria. Tables 1 and 2 show the results.

(Criteria)

Good: Oxygen transmission rate is less than 2 cc/m$^2$·day·atm.
Fair: Oxygen transmission rate is 2 cc/m$^2$·day·atm or more and less than 3 cc/m$^2$·day·atm.
Poor: Oxygen transmission rate is 3 cc/m$^2$·day·atm or more.

(Evaluation of Water Vapor Barrier Properties)

The water vapor barrier properties of the above test samples were evaluated according to the following criteria. Tables 1 and 2 show the results.

(Criteria)

Good: Water vapor transmission rate is less than 1 g/m$^2$·day.
Fair: Water vapor transmission rate is 1 g/m$^2$·day or more and less than 2 g/m$^2$·day.
Poor: Water vapor transmission rate is 2 g/m$^2$·day or more.

(2) Evaluation of Abuse Resistance

(Gelbo Flex Test)

For evaluation of abuse resistance of the gas barrier films, the laminate films prepared as described above were subjected to Gelbo flex test.

Specifically, the laminate film prepared as described above was formed into a hollow cylindrical body with a 87.5 mm diameter × 210 mm. Then, the hollow cylindrical body was attached to a fixed head of a Gelbo Flex Tester (trade name "Gelbo flex tester", manufactured by Tester Sangyo Co., Ltd) with both ends of the hollow cylindrical body being held. Then, with an initial gripping interval set to 175 mm and a stroke set to 87.5 mm, a reciprocation motion of repeatedly applying a twist of 440 degrees was performed 10 times at a speed of 40 times/min. to bend the hollow cylindrical body. Thus, the Gelbo flex test was performed.

Then, the oxygen transmission rate and water vapor transmission rate of the laminate films after the Gelbo flex test were measured in the same manner as in the evaluation of the oxygen barrier properties and water vapor barrier properties after the retort treatment. Tables 1 and 2 show the results.

Subsequently, based on the oxygen transmission rate and water vapor transmission rate, evaluation of the oxygen barrier properties and water vapor barrier properties was performed as follows.

(Evaluation of Oxygen Barrier Properties)

The oxygen barrier properties were evaluated according to the following criteria. Tables 1 and 2 show the results.

(Criteria)

Good: Oxygen transmission rate is less than 10 cc/m$^2$·day·atm.
Fair: Oxygen transmission rate is 10 cc/m$^2$·day·atm or more and less than 15 cc/m$^2$·day·atm.
Poor: Oxygen transmission rate is 15 cc/m$^2$·day·atm or more.

(Evaluation of Water Vapor Barrier Properties)

The water vapor barrier properties were evaluated according to the following criteria. Tables 1 and 2 show the results.

(Criteria)

Good: Water vapor transmission rate is less than 1.5 g/m$^2$·day.
Fair: Water vapor transmission rate is 1.5 g/m$^2$·day or more and less than 2.5 g/m$^2$·day.
Poor: Water vapor transmission rate is 2.5 g/m$^2$·day or more.

(Pass/Fail Judgment of Abuse Resistance)

The abuse resistance was judged as a pass when at least one of the oxygen barrier properties and water vapor barrier properties of the laminate film after the Gelbo flex test were good or fair.

(3) Evaluation of Lamination Strength after Retort Treatment

(Measurement of Lamination Strength)

First, the lamination strength of the above test samples was measured as follows. That is, the lamination strength of the test samples was measured according to JIS Z-1707. Specifically, the test sample was cut into a strip shape of 15 mm width. Next, the gas barrier film of the test sample cut into a strip shape was peeled off from the CPP film using a Tensilon tensile tester (trade name "Tensilon RTC-1250", manufactured by Orientec Corporation) so that the gas barrier film and the CPP film were pulled into the opposite directions (that is, at a T-shaped peel angle) at a peeling rate of 300 mm/minute, and the strength required for peeling (unit: N/15 mm) was measured as the lamination strength.

(Evaluation of Lamination Strength)

The lamination strength was evaluated according to the following criteria. Tables 1 and 2 show the results.

(Criteria)

Good: Lamination strength is 2 N/N/15 mm or more.
Fair: Lamination strength is 1.5 N/15 mm or more and less than 2 N/15 mm.
Poor: Lamination strength is less than 1.5 N/15 mm.

(Pass/Fail judgment of Lamination Strength)

The lamination strength after the resist treatment was judged as a pass when the evaluation rank was good or fair.

(4) Evaluation of Effect of Suppressing Bleed-Out

The surfaces of the gas barrier films of Examples 1 to 11 and Comparative Examples 1 to 8 were observed visually and by touch. The effect of suppressing bleed-out was evaluated according to the following criteria. The effect of suppressing bleed-out was judged as a pass when the evaluation was good.

(Criteria)

Good: No bleed-out occurred on the surface of gas barrier film
Poor: Bleed-out of curing agent occurred on the surface of gas barrier film, and tackiness also observed

(5) Evaluation of Recyclability

A mono-recycling ratio of the laminate films obtained as described above was calculated based on the following formula, and a recyclability was evaluated based on the mono-recycling ratio and the following criteria. Tables 1 and 2 show the results.

Mono-recycling ratio (%)

= 100 ×

(Thickness of resin substrate made of PP × Specific gravity + Thickness of CPP layer × Specific

gravity)/

(Thickness of resin substrate × Specific gravity

+ Thickness of primer layer × Specific gravity

+ Thickness of metal oxide layer × Specific gravity

+ Thickness of gas barrier film × Specific gravity

+ Thickness of adhesive × Specific gravity

+ Thickness of CPP layer × Specific gravity)

(Criteria)

Good: Mono-recycling ratio is 90% or more
Poor: Mono-recycling ratio is less than 90%

[Table 1]

| | Resin substrate | Inorganic oxide layer | Coating solution | | | | | | Gas barrier layer Thickness (nm) | After retort treatment | | | | Abuse resistance | | | | Delamination resistance | | Bleed-out suppressing effect | Recyclability | |
| | | | No. | Solid content mass ratio | PU | WSP | CA | IM | | Oxygen transmission rate [cc/m²·day·atm] | | Water vapor transmission rate [cc/m²·day·atm] | | Oxygen transmission rate [cc/m²·day·atm] | | Water vapor transmission rate [cc/m²·day·atm] | | Lamination strength [N/15mm] | | | Mono-material ratio (%) | Evaluation |
| | | | | | | | | | | After retort treatment | Evaluation | After retort treatment | Evaluation | After Gelbo flex test | Evaluation | After Gelbo flex test | Evaluation | After retort treatment | Evaluation | | | |
| Ex.1 | PP | AlOx | 1 | PU:WSP:CA:IM=60:25:15:0 | A1 | PAA | epoxysilane | - | 400 | 2.6 | Fair | 1.8 | Fair | 9.5 | Good | 2.0 | Fair | 3.6 | Good | Good | 96.5 | Good |
| Ex.2 | PP | AlOx | 2 | PU:WSP:CA:IM=60:25:15:0 | A1 | PVA | aminosilane | - | 400 | 1.5 | Good | 1.6 | Fair | 7.8 | Good | 1.8 | Fair | 1.8 | Fair | Good | 96.5 | Good |
| Ex.3 | PP | SiOx | 3 | PU:WSP:CA:IM=60:25:15:0 | A1 | PVA | epoxysilane | - | 100 | 2.3 | Fair | 1.4 | Fair | 9.7 | Good | 0.7 | Good | 3.9 | Good | Good | 97.0 | Good |
| Ex.4 | PP | SiOx | 4 | PU:WSP:CA:IM=75:20:5:0 | A1 | PVA | epoxysilane | - | 850 | 0.8 | Good | 0.5 | Good | 13.2 | Fair | 2.1 | Fair | 4.3 | Good | Good | 96.0 | Good |
| Ex.5 | PP | SiOx | 4 | PU:WSP:CA:IM=75:20:5:0 | A1 | PVA | epoxysilane | - | 400 | 0.7 | Good | 0.8 | Good | 8.7 | Good | 1.0 | Good | 3.2 | Good | Good | 96.6 | Good |
| Ex.6 | PP | SiOx | 5 | PU:WSP:CA:IM=45:35:20:0 | A1 | PVA | epoxysilane | - | 400 | 0.5 | Good | 0.7 | Good | 7.1 | Good | 0.8 | Good | 2.8 | Good | Good | 96.5 | Good |
| Ex.7 | PP | SiOx | 5 | PU:WSP:CA:IM=45:35:20:0 | A1 | PVA | epoxysilane | - | 850 | 0.4 | Good | 0.5 | Good | 13.8 | Fair | 1.7 | Fair | 3.0 | Good | Good | 95.9 | Good |
| Ex.8 | PP | SiOx | 3 | PU:WSP:CA:IM=60:25:15:0 | A1 | PVA | epoxysilane | - | 400 | 0.6 | Good | 0.8 | Good | 6.5 | Good | 0.8 | Good | 4.1 | Good | Good | 96.6 | Good |

| | | | | | | | | | | | | | | | | | | | | | |
|---|---|---|---|---|---|---|---|---|---|---|---|---|---|---|---|---|---|---|---|---|---|---|
| Ex.9 | PP | SiOx | 13 | PU:WSP:CA:IM=60:25:14:1 | A1 | PVA | epoxysilane | Synthetic mica | 400 | 0.7 | Good | 1.0 | Good | 14.7 | Good | 0.9 | Good | 4.3 | Good | Good | 96.5 | Good |
| Ex.10 | PET | SiOx | 3 | PU:WSP:CA:IM=60:25:15:0 | A1 | PVA | epoxysilane | - | 400 | 0.5 | Good | 0.6 | Good | 8.3 | Good | 0.7 | Good | 5.2 | Good | Good | 73.8 | Poor |
| Ex.11 | PP | SiOx | 5 | PU:WSP:CA:IM=45:35:20:0 | A1 | PVA | epoxysilane | - | 750 | 0.5 | Good | 0.6 | Good | 10.2 | Fair | 1.4 | Fair | 3.1 | Good | Good | 96.1 | Good |

(Note) PP: polypropylene resin, PET: polyethylene terephthalate resin, PU: polyurethane resin, WSP: water soluble polymer, CA: curing agent, IM: inorganic layered mineral

[Table 2]

| | Resin substrate | Inorganic oxide layer | Coating solution | | | | | | Gas barrier layer | After retort treatment | | | | Abuse resistance | | | | Delamination resistance | | Bleed-out suppressing effect | Recyclability | |
| | | | | | | | | | | Oxygen transmission rate [cc/m²·day·atm] | | Water vapor transmission rate [g/m²·day] | | Oxygen transmission rate [cc/m²·day·atm] | | Water vapor transmission rate [g/m²·day] | | Lamination strength [N/15mm] | | | Mono-material ratio (%) | Evaluation |
| | | | No. | Solid content mass ratio | PU | WSP | CA | IM | Thickness (nm) | After retort treatment | Evaluation | After retort treatment | Evaluation | After Gelbo flex test | Evaluation | After Gelbo flex test | Evaluation | After retort treatment | Evaluation | | | |
| Comp.Ex.1 | PP | SiOx | 6 | PU:WSP:CA:IM=100:0:0:0 | A1 | - | - | - | 400 | 1.9 | Good | 0.7 | Good | 18.5 | Poor | 2.8 | Poor | 4.5 | Good | Good | 96.6 | Good |
| Comp.Ex.2 | PP | SiOx | 7 | PU:WSP:CA:IM=100:0:0:0 | A1 | PVA | - | - | 400 | 2.3 | Fair | 1.7 | Fair | 6.5 | Good | 1.0 | Good | 1.2 | Poor | Good | 96.5 | Good |
| Comp.Ex.3 | PP | SiOx | 8 | PU:WSP:CA:IM=65:35:0:0 | A1 | PVA | - | - | 400 | 0.9 | Good | 0.6 | Good | 7.2 | Good | 0.8 | Good | 1.4 | Poor | Good | 96.5 | Good |
| Comp.Ex.4 | PP | SiOx | 9 | PU:WSP:CA:IM=75:15:10:0 | A1 | PVA | epoxysilane | - | 400 | 1.3 | Good | 1.0 | Good | 15.5 | Poor | 2.9 | Fair | 4.2 | Good | Good | 96.6 | Good |
| Comp.Ex.5 | PP | SiOx | 10 | PU:WSP:CA:IM=55:40:5:0 | A1 | PVA | epoxysilane | - | 400 | 0.8 | Good | 0.5 | Good | 7.5 | Good | 0.7 | Good | 0.9 | Poor | Good | 96.5 | Good |
| Comp.Ex.6 | PP | SiOx | 11 | PU:WSP:CA:IM=80:20:0:0 | A1 | PVA | epoxysilane | - | 400 | 0.9 | Good | 0.7 | Good | 14.2 | Fair | 1.8 | Fair | 1.4 | Poor | Good | 96.6 | Good |
| Comp.Ex.7 | PP | SiOx | 12 | PU:WSP:CA:IM=60:25:10:5 | A1 | PVA | epoxysilane | Synthetic mica | 400 | Not measurable | Poor | Not measurable | Poor | 19.5 | Poor | 2.7 | Poor | 0.1 | Poor | Good | 96.6 | Good |
| Comp.Ex.8 | PP | SiOx | 14 | PU:WSP:CA:IM=60:25:15:0 | A2 | PVA | epoxysilane | - | 400 | 9.8 | Poor | 1.9 | Poor | 25.2 | Poor | 2.5 | Poor | 4.1 | Good | Good | 96.6 | Good |

EP 4 245 520 A1

(Note) PP: polypropylene resin, PET: polyethylene terephthalate resin, PU: polyurethane resin, WSP: water soluble polymer, CA: curing agent, IM: inorganic layered mineral

"Not measurable" indicates that measurement failed due to delamination occurred in the test film.

As shown in Tables 1 and 2, all the gas barrier films of Examples 1 to 11 are found to satisfy the pass criteria for the abuse resistance, lamination strength after retort treatment, and effect of suppressing bleed-out. On the other hand, the gas barrier films of Comparative Examples 1 to 8 are found not to satisfy at least one of the abuse resistance, lamination strength after retort treatment, and effect of suppressing bleed-out.

As seen from the above, the gas barrier layer-forming composition of the present disclosure is found to impart excellent abuse resistance and high lamination strength even after applying retort treatment to the gas barrier film, and suppress occurrence of bleed-out.

[Reference Signs List]

1 ... Resin substrate
4 ... Gas barrier layer
10 ... Gas barrier film
20 ... Packaging film
21 ... Sealant layer
30 ... Packaging bag
100 ... Spouted packaging bag
104 ... Spout
105 ... Straw
140 ... Packaging bag
500 ... Tube container
510 ... Body
520 ... Spout unit
530 ... Cap

**Claims**

1. A gas barrier layer-forming composition containing a solid content containing:

   a polyurethane resin (A);
   a water-soluble polymer (B); and
   a curing agent (C), wherein
   the polyurethane resin (A) contains a reaction product of an acid group-containing polyurethane resin having an acid group and a polyamine compound having an amino group, and
   the polyurethane resin (A) content, the water-soluble polymer (B) content and an inorganic layered mineral (D) content in the solid content are 45 mass% or more and 75 mass% or less, 20 mass% or more and 35 mass% or less, and less than 2 mass%, respectively.

2. The gas barrier layer-forming composition according to claim 1, wherein
   the inorganic layered mineral (D) content in the solid content is 0 mass%, and a total content of the polyurethane resin (A), the water-soluble polymer (B) and the curing agent (C) in the solid content is 100 mass%.

3. The gas barrier layer-forming composition according to claim 1 or 2, wherein
   the curing agent (C) content in the solid content is 20 mass% or less.

4. The gas barrier layer-forming composition according to any one of claims 1 to 3, wherein
   the curing agent (C) content in the solid content is 5 mass% or more.

5. The gas barrier layer-forming composition according to any one of claims 1 to 4, wherein
   the water-soluble polymer (B) is a polyvinyl alcohol resin or a modified product thereof.

6. The gas barrier layer-forming composition according to any one of claims 1 to 5, wherein
   the water-soluble polymer (B) is a polyvinyl alcohol resin, and the polyvinyl alcohol resin is composed of a homopolymer of vinyl alcohol or a vinyl alcohol-vinyl acetate copolymer.

**7.** The gas barrier layer-forming composition according to any one of claims 1 to 6, wherein the water-soluble polymer (B) has no silanol group.

**8.** The gas barrier layer-forming composition according to any one of claims 1 to 7, wherein the curing agent (C) has an epoxy group.

**9.** A gas barrier film comprising:

a resin substrate; and
a gas barrier layer disposed on a first surface side of the resin substrate, the gas barrier layer being composed of a cured product of the gas barrier layer-forming composition according to any one of claims 1 to 8.

**10.** The gas barrier film according to claim 9, wherein the gas barrier layer has a thickness of 800 nm or less.

**11.** The gas barrier film according to claim 9 or 10, wherein the gas barrier layer has a thickness of 150 nm or more.

**12.** The gas barrier film according to any one of claims 9 to 11, further comprising an inorganic oxide layer disposed between the resin substrate and the gas barrier layer, the inorganic oxide layer containing an inorganic oxide.

**13.** The gas barrier film according to claim 12, wherein the inorganic oxide is composed of silicon oxide.

**14.** A packaging film comprising:

the gas barrier film according to any one of claims 9 to 13; and
a sealant layer laminated on the gas barrier film.

**15.** A packaging bag formed by using the packaging film according to claim 14 and bonding each of the sealant layer to the other.

**16.** A method of producing a gas barrier film having a resin substrate and a gas barrier layer disposed on a first surface side of the resin substrate, the method comprising:
a gas barrier layer forming step of forming the gas barrier layer by curing the gas barrier layer-forming composition according to any one of claims 1 to 8 on a first surface side of the resin substrate to form a gas barrier film.

**17.** A method of producing a packaging film, the method comprising:

a gas barrier film producing step of producing a gas barrier film by the method of producing a gas barrier film according to claim 16; and
a sealant layer lamination step of laminating a sealant layer on the gas barrier film to obtain a packaging film.

**18.** A method of producing a packaging bag, the method comprising:

a packaging film producing step of producing a packaging film by the method of producing a packaging film according to claim 17; and
a packaging film bonding step of using the packaging film and bonding each of the sealant layer to the other to produce a packaging bag.

FIG.1

# FIG.2

# FIG.3

# FIG.4

# FIG.5

## INTERNATIONAL SEARCH REPORT

International application No.

**PCT/JP2021/037398**

**A.  CLASSIFICATION OF SUBJECT MATTER**

*B32B 9/00*(2006.01)i; *B32B 9/04*(2006.01)i; *B32B 27/26*(2006.01)i; *B32B 27/40*(2006.01)i; *B65D 65/40*(2006.01)i;
*C08K 5/54*(2006.01)i; *C08K 7/00*(2006.01)i; *C08L 29/04*(2006.01)i; *C08L 75/04*(2006.01)i; *C08L 101/14*(2006.01)i;
*C09D 129/02*(2006.01)i; *C09D 129/04*(2006.01)i; *C09D 175/04*(2006.01)i
FI:   C09D175/04; C09D129/04; B32B27/40; B32B9/00 A; B32B9/04; B32B27/26; C09D129/02; C08K5/54; C08K7/00;
B65D65/40 D; C08L101/14; C08L29/04 D; C08L75/04

According to International Patent Classification (IPC) or to both national classification and IPC

**B.  FIELDS SEARCHED**

Minimum documentation searched (classification system followed by classification symbols)

B32B9/00; B32B9/04; B32B27/00-27/42; B65D65/40; C08K5/54; C08K7/00; C08L29/04; C08L75/04; C08L101/14;
C09D1/00-201/10

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
|---|---|---|
| X | JP 2020-164559 A (SAKATA INKS) 08 October 2020 (2020-10-08)<br>paragraphs [0063]-[0072], [0076], tables 1-2, examples 1-2, comparative examples 1-2 | 1-18 |
| A | WO 2017/217474 A1 (FUJIFILM CORP) 21 December 2017 (2017-12-21)<br>paragraph [0185] | 1-18 |
| A | JP 2009-269218 A (MITSUI CHEMICALS INC) 19 November 2009 (2009-11-19)<br>paragraph [0120] | 10-11 |
| A | JP 2020-143247 A (JUJO PAPER CO LTD) 10 September 2020 (2020-09-10)<br>paragraph [0043] | 10-11 |
| A | JP 2017-222151 A (TOPPAN PRINTING CO LTD) 21 December 2017 (2017-12-21)<br>entire text, all drawings | 1-18 |

[✓] Further documents are listed in the continuation of Box C.      [✓] See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **06 December 2021** | **21 December 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2021/037398**

**C.      DOCUMENTS CONSIDERED TO BE RELEVANT**

| Category* | Citation of document, with indication, where appropriate, of the relevant passages | Relevant to claim No. |
|---|---|---|
| A | WO 2020/116544 A1 (TOPPAN PRINTING CO LTD) 11 June 2020 (2020-06-11) entire text, all drawings | 1-18 |
| A | JP 2019-195936 A (TOPPAN PRINTING CO LTD) 14 November 2019 (2019-11-14) entire text, all drawings | 1-18 |
| A | JP 2017-71693 A (TOPPAN PRINTING CO LTD) 13 April 2017 (2017-04-13) entire text | 1-18 |
| A | WO 2016/171171 A1 (TOPPAN PRINTING CO LTD) 27 October 2016 (2016-10-27) entire text | 1-18 |

Form PCT/ISA/210 (second sheet) (January 2015)

**INTERNATIONAL SEARCH REPORT**
Information on patent family members

International application No.

**PCT/JP2021/037398**

| Patent document cited in search report | | | Publication date (day/month/year) | Patent family member(s) | Publication date (day/month/year) |
|---|---|---|---|---|---|
| JP | 2020-164559 | A | 08 October 2020 | (Family: none) | |
| WO | 2017/217474 | A1 | 21 December 2017 | US 2019/0100674 A1 paragraph [0335] | |
| JP | 2009-269218 | A | 19 November 2009 | (Family: none) | |
| JP | 2020-143247 | A | 10 September 2020 | (Family: none) | |
| JP | 2017-222151 | A | 21 December 2017 | (Family: none) | |
| WO | 2020/116544 | A1 | 11 June 2020 | (Family: none) | |
| JP | 2019-195936 | A | 14 November 2019 | (Family: none) | |
| JP | 2017-71693 | A | 13 April 2017 | (Family: none) | |
| WO | 2016/171171 | A1 | 27 October 2016 | US 2018/0037769 A1 entire text | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017222151 A